(19) **Europäisches Patentamt / European Patent Office / Office européen des brevets**

(11) **EP 4 453 555 B1**

(12) **FASCICULE DE BREVET EUROPEEN**

(45) Date de publication et mention de la délivrance du brevet:
**25.02.2026 Bulletin 2026/09**

(21) Numéro de dépôt: **22840768.0**

(22) Date de dépôt: **22.12.2022**

(51) Classification Internationale des Brevets (IPC):
**G01N 27/02** $^{(2006.01)}$    **G01N 27/72** $^{(2006.01)}$
**G01R 33/16** $^{(2006.01)}$    **G21C 21/00** $^{(2006.01)}$
**G21C 3/62** $^{(2006.01)}$

(52) Classification Coopérative des Brevets (CPC):
**G01R 33/16; G01N 27/023; G01N 27/72; G21C 21/00;** G21C 3/623

(86) Numéro de dépôt international:
**PCT/EP2022/087436**

(87) Numéro de publication internationale:
**WO 2023/118413 (29.06.2023 Gazette 2023/26)**

(54) **PROCÉDÉ ET SYSTÈME POUR LA MESURE DE CONCENTRATIONS RELATIVES DE MATÉRIAUX D'UN MÉLANGE PAR MESURE DE SUSCEPTIBILITÉ MAGNÉTIQUE DYNAMIQUE**

VERFAHREN UND SYSTEM ZUR MESSUNG DER RELATIVEN KONZENTRATIONEN VON MATERIALIEN IN EINER MISCHUNG DURCH MESSUNG DER DYNAMISCHEN MAGNETISCHEN SUSZEPTIBILITÄT

METHOD AND SYSTEM FOR MEASURING RELATIVE CONCENTRATIONS OF MATERIALS IN A MIXTURE BY MEASURING DYNAMIC MAGNETIC SUSCEPTIBILITY

(84) Etats contractants désignés:
**AL AT BE BG CH CY CZ DE DK EE ES FI FR GB GR HR HU IE IS IT LI LT LU LV MC ME MK MT NL NO PL PT RO RS SE SI SK SM TR**

(30) Priorité: **22.12.2021 FR 2114295**

(43) Date de publication de la demande:
**30.10.2024 Bulletin 2024/44**

(73) Titulaire: **Commissariat à l'Energie Atomique et aux Energies Alternatives**
**75015 Paris (FR)**

(72) Inventeurs:
- **PANNETIER-LECOEUR, Myriam**
  **91191 GIF SUR YVETTE CEDEX (FR)**
- **FERMON, Claude**
  **91191 GIF SUR YVETTE CEDEX (FR)**
- **SOLIGNAC, Aurélie**
  **91191 GIF SUR YVETTE CEDEX (FR)**
- **MARTINEZ, Julien**
  **30200 BAGNOLS SUR CEZE CEDEX (FR)**
- **ROYET, Vincent**
  **30200 BAGNOLS SUR CEZE CEDEX (FR)**

(74) Mandataire: **Ipsilon**
**12 Avenue d'Italie**
**75013 Paris (FR)**

(56) Documents cités:
FR-A1- 2 433 181     JP-A- S60 114 766
US-A- 4 134 064

- **KAZUTO KODAMA: "A new system for measuring alternating current magnetic susceptibility of natural materials over a wide range of frequencies", G3: GEOCHEMISTRY, GEOPHYSICS, GEOSYSTEMS, WILEY-BLACKWELL PUBLISHING, INC, US, vol. 11, no. 11, 9 November 2010 (2010-11-09), pages n/a, XP072301233, ISSN: 1525-2027, DOI: 10.1029/2010GC003303**

Il est rappelé que: Dans un délai de neuf mois à compter de la publication de la mention de la délivrance du brevet européen au Bulletin européen des brevets, toute personne peut faire opposition à ce brevet auprès de l'Office européen des brevets, conformément au règlement d'exécution. L'opposition n'est réputée formée qu'après le paiement de la taxe d'opposition. (Art. 99(1) Convention sur le brevet européen).

## Description

### Domaine technique

La présente invention concerne le domaine de la mesure de concentrations de matériaux au sein d'un mélange, notamment un mélange binaire.

L'invention vise principalement à optimiser ce type de mesure, en proposant une solution compacte, fiable, rapide, non destructive et qui permette une intégration dans un environnement contraignant, notamment en termes d'espace disponible, et/ou dans une ligne de production en continu.

Bien que décrite en référence à la mesure du contenu relatif de plutonium (Pu) et d'uranium (U), et des oxydes associés sous forme de poudres ou de pastilles de combustible MOX, l'invention s'applique à la mesure de pourcentages massiques relatifs de matériaux solides présentant chacun une susceptibilité magnétique donnée d'un mélange binaire, ou de manière plus générale à toute mesure de n'importe quel mélange de matériaux même non binaire présentant chacun une susceptibilité magnétique donnée.

Au titre d'un autre exemple, l'invention s'applique au cas d'un matériau solide et/ou d'un mélange contenant des impuretés (de type ferromagnétiques ou métalliques) dont la susceptibilité même en concentration faible dans le mélange, présente une signature de susceptibilité largement supérieure (au moins un ordre de grandeur) à la susceptibilité des autres constituants.

### Technique antérieure

La fabrication de pastilles de combustible nucléaires neufs de type MOX (acronyme anglais pour « Mixed OXide Fuel ») consiste en un procédé comprenant successivement les étapes de mélange d'une poudre de dioxyde d'$UO_2$ et de $PuO_2$, de pressage et de frittage. Le mélange peut éventuellement être complété par de la chamotte (rebuts de fabrication de pastilles).

Les pastilles de combustibles MOX obtenues peuvent, par exemple, être irradiées dans des réacteurs à eau légère (ou REL) ou des réacteurs à neutrons rapides (ou RNR).

La reproductibilité de la composition en plutonium ou uranium des pastilles est une des contraintes majeures de la fabrication. Ainsi, il s'avère important de connaître la composition systématiquement pour chaque lot de production.

Plus précisément, il est nécessaire de connaitre notamment les concentrations massiques relatives, ou autrement dit les pourcentages en masse relatifs d'oxydes de Pu et d'U et des oxydes associés, dans des pastilles de MOX issues d'une chaine de production. Cette connaissance doit pouvoir être faite soit en laboratoire d'analyses soit dans un dispositif compact à installer en boite à gants nucléaire ou sur une ligne de production en continu.

Les solutions actuellement mises en œuvre pour réaliser la mesure des concentrations relatives sont des méthodes nécessitant des analyses chimiques poussées des pastilles.

Bien que précises et sélectives, les analyses chimiques sont destructives, longues, typiquement d'une durée de plusieurs heures/jours avant l'obtention des résultats, ne sont pas réellement applicables de manière systématique, et nécessitent un prélèvement sur une chaîne de production, ce qui limite les statistiques sur un lot de production.

Des solutions par spectroscopie ont également été proposées. Elles présentent les mêmes inconvénients que les analyses chimiques.

Une autre solution de mesure par magnétométrie (acronyme anglais VSM pour « Vibrating Sample Magnetometry ») a également été proposée. Elle consiste à mesurer sous un champ magnétique statique, variable et de forte valeur, typiquement supérieure à 1 tesla, le moment magnétique de l'échantillon de pastille. Cette technique standard en laboratoire nécessite la mise en œuvre d'un électro-aimant ou aimant supraconducteur de grande taille. De ce fait, l'insertion de ce dernier quasi-impossible en boite à gants ou sur une chaine de production nucléaire rend une telle solution par mesure VSM rédhibitoire.

Les demandes JP S60 114766 A, US 4 134 064 A et FR 2 433 181 A1 décrivent chacune un procédé et un appareil permettant de déterminer magnétiquement la teneur en $Gd_2O_3$ dans des pastilles de combustible $UO_2$.

Il existe par conséquent un besoin pour améliorer les solutions de mesure de concentrations massiques de matériaux au sein d'un mélange, notamment un mélange binaire, notamment en termes d'encombrement afin de pouvoir l'implanter dans un environnement contraignant, tel qu'un environnement nucléaire, et/ou sur une ligne de production en continu d'objets, tels que des pastilles de combustible MOX.

Le but de l'invention est de répondre au moins en partie à ce besoin.

### Exposé de l'invention

Pour ce faire, l'invention concerne, selon la revendication indépendante 1, un procédé de mesure de concentrations relatives de matériaux d'un mélange comprenant les étapes suivantes :

a/ fourniture d'une bobine d'émission et d'au moins une bobine de réception ;

b/ fourniture d'un mélange comprenant n matériaux de susceptibilités magnétiques différentes ($\chi$1, $\chi$2 .. $\chi$n);

c/ insertion du mélange dans la bobine de réception ;

d/ alimentation par un générateur de tension électrique de la bobine d'émission à au moins une fréquence d'excitation, non nulle de sorte à générer un champ magnétique d'excitation ;

e/ mesure du signal de la tension électrique induite dans au moins une bobine de réception ;

f/ détermination des concentrations des n matériaux à partir de la comparaison de susceptibilité globale du mélange obtenue par la mesure de tension selon l'étape e/ avec celle d'un mélange de référence dont les concentrations relatives desdits n matériaux sont connues, le procédé étant caractérisé en ce que l'étape d/ comprend l'application de la tension électrique donnée en faisant varier la au moins une fréquence d'excitation.

Selon un mode de réalisation avantageux, dans le cas où n=2, le procédé comprend à l'étape f) à partir de la masse du mélange m(mel)=m1+m2, la détermination de la susceptibilité du mélange donnée par la relation :

$$\chi\text{mel} = \frac{m1\chi1}{m1+m2} + \frac{m2\chi2}{m1+m2}$$

et connaissant les susceptibilités magnétiques différentes ($\chi$1, $\chi$2), la détermination des concentrations massiques respectives des matériaux par les relations suivantes :

$$m1 = m(mel)\left(\frac{\chi mel - \chi2}{\chi1 - \chi2}\right)$$

et

$$m2 = m(mel)\left(\frac{\chi mel - \chi1}{\chi2 - \chi1}\right).$$

Selon une variante avantageuse, le procédé comporte en outre, à l'étape e/ soit une mesure en phase du signal de la tension électrique induite dans la au moins une bobine de réception et soit une mesure en quadrature de phase de sorte à obtenir le module du signal. Avantageusement, la bobine de réception est accordée de sorte que sa fréquence de résonance est sensiblement égale à au moins une fréquence d'excitation.

Le mélange fourni selon l'étape b/ peut être un mélange binaire de matériaux de deux susceptibilités magnétiques différentes ($\chi$1, $\chi$2).

Selon un mode de réalisation avantageux, le procédé comprend après l'étape b), une étape b1/ comportant une pesée du mélange de sorte à obtenir à l'étape f) une concentration massique relative dudit mélange.

Le mélange fourni selon l'étape b/ peut être un mélange comprenant plus de deux matériaux, l'un des matériaux présentant une susceptibilité très supérieure à celle des autres matériaux. Les autres matériaux peuvent être des impuretés ferromagnétiques ou métalliques..., Ainsi, l'invention permet de mesurer la susceptibilité d'un constituant même avec une concentration faible par rapport aux autres constituants du mélange à condition que ce constituant ait une susceptibilité très supérieure à celles des autres matériaux par exemple d'un facteur 100.

Dans ce cas en effet, la susceptibilité du mélange, donnée par :

$$\chi\text{mel} = \frac{m1\chi1}{\sum(m1+m2+\cdots mn)} + \frac{m2\chi2}{\sum(m1+m2+\cdots mn)} + \cdots + \frac{mn\chi n}{\sum(m1+m2+\cdots mn)}$$

avec les masses et susceptibilités respectives de n matériaux du mélange, se simplifie si l'un des matériaux (ici de masse m1 et susceptibilité $\chi$1) a une susceptibilité très supérieure à celle des autres à :

$$\chi\text{mel} = \frac{m1\chi1}{\sum(m1+m2+\cdots mn)}$$

Selon une application privilégiée, le mélange fourni selon l'étape b/ peut être sous la forme d'un composé solide. Par « composé solide » on entend ici et dans le cadre de l'invention aussi bien une pastille compacte qu'une poudre ou tout autre structure solide.

Selon une variante de réalisation avantageuse, l'étape d/ comprend l'application d'une tension donnée en faisant varier la fréquence d'excitation.

De préférence, la fréquence d'excitation est supérieure à 10 kHz, de préférence supérieure à 100 kHz, de préférence comprise entre 100 et 250 kHz.

Selon une première configuration, l'étape a/ comprend la fourniture d'une unique bobine de réception, le procédé comprenant en outre avant l'étape c/, la réalisation des étapes e/ et f/ de sorte à obtenir le signal de base représentatif de l'unique bobine de réception vide.

Alternativement, l'étape a/ comprend la fourniture de deux bobines de réception, de préférence identiques, le procédé comprenant avant l'étape f/, la réitération des étapes c/ à d/ avec chacune des deux bobines de réception, et une étape supplémentaire e1/ de soustraction entre les deux mesures des signaux induits par les deux bobines.

Selon cette alternative, le procédé comprend avantageusement la mise en série électrique des deux bobines de réception de préférence montées avec des bobinages inversés et l'accord de leurs fréquences de réception respectives. Cela permet d'améliorer le rapport signal de sortie sur bruit et d'augmenter le signal de sortie, la mesure se réalisant autour de la fréquence de résonance des bobines de réception.

De préférence, l'étape e/ est réalisée pour chaque fréquence d'excitation, avec une détection synchrone.

De préférence encore, l'étape e/ peut consister en plusieurs mesures, chacune à une fréquence de réception autour de la fréquence de résonance de la ou des bobines de détection. Avantageusement, l'étape d/ est réalisée de sorte à générer un champ magnétique d'excitation de valeur inférieure à 50mT, de préférence compris entre 1 et 20mT. Ce faible champ magnétique a pour avantage de ne pas nécessiter de bobine de dimensions importantes pour le générer, ce qui rend la partie acquisition du système compact et donc compatible avec un encombrement restreint.

Selon un mode de réalisation avantageux, lorsque le mélange comprend un matériau ferromagnétique, comprenant avant l'étape c/, une étape supplémentaire b2/ consistant à exposer le mélange à un champ magnétique constant.

L'invention a également pour objet un système pour la mesure de concentrations relatives de matériaux d'un mélange selon la revendication indépendante 10, comprenant:

- un générateur de tension électrique à au moins une fréquence dite d'excitation;
- une bobine d'émission reliée au générateur;
- au moins une bobine de réception dont la forme est adaptée pour recevoir un mélange comprenant au moins deux matériaux de susceptibilités magnétiques différentes et dont la fréquence de réception est accordée à la au moins une fréquence d'excitation;
- des moyens de mesure de la tension reliés à la (ou les) bobine (s) de réception.

De préférence, le générateur est un générateur basse fréquence, (GBF) à fréquence variable. De préférence, le générateur est configuré de sorte que la fréquence d'excitation est supérieure à 10 kHz, de préférence à 100 kHz, de préférence comprise entre 100 et 250 kHz.

Typiquement, pour un mélange d'oxydes à susceptibilité magnétique de l'ordre du dixième à la dizaine de millimu.mol$^{-1}$, la gamme de fréquences peut être comprise entre 100 et 250 kHz.

On précise que la fréquence est choisie indépendamment de la valeur des susceptibilités, mais suivant le design des bobines. Par conséquent, le système selon l'invention n'a pas besoin d'être ajusté au type de matériau, mais plutôt aux dimensions de l'échantillon à analyser.

Selon une alternative de configuration, le système comprend deux bobines de réception en série électrique et dont leurs fréquences de réception respectives sont accordées.

Selon une variante d'agencement, la(les) bobine(s) de réception est(sont) agencée(s) à l'intérieur de la bobine d'excitation. La partie acquisition du système (bobines d'émission et de réception des connexions électriques afférentes) est ainsi compacte.

Selon un mode de réalisation avantageux, le système comprend en outre :

- un boitier de protection électromagnétique ;
- un premier connecteur monté dans le boitier, relié à la bobine d'émission par un premier fil d'alimentation électrique à l'intérieur du boitier, le premier connecteur étant destiné à être relié à distance au générateur par un premier câble d'alimentation électrique ;
- un deuxième connecteur monté dans le boitier, relié à au moins une bobine de réception par un deuxième fil d'alimentation électrique à l'intérieur du boitier; le deuxième connecteur étant destiné à être relié à distance aux moyens de mesure par un deuxième câble d'alimentation électrique. Avec un tel agencement, on facilite l'intégration du système dans un environnement contraignant, notamment nucléaire, tel qu'une boîte à gants, en particulier grâce à la limitation des câbles d'interface entre le boitier qui loge la partie acquisition de mesure (bobines) et l'électronique de mesure, cette dernière ainsi que le générateur d'alimentation électrique n'ayant pas à être agencé dans l'environnement nucléaire.

En outre, cela rend la partie acquisition de mesures (bobines) immune aux radiations puisque grâce aux câbles d'interface avec le boitier, l'électronique de mesure ainsi que le générateur d'alimentation peuvent être positionnés à distance en dehors de l'environnement dans lequel sont émises les radiations.

Selon une variante de réalisation avantageuse, les moyens de mesure comprennent un amplificateur à détection synchrone.

Selon une configuration avantageuse, la ou les bobines de réception sont agencées coaxialement à l'intérieur de la bobine d'émission en définissant en leur sein un passage d'une partie d'un convoyeur adapté pour déplacer le mélange sous la forme d'un produit solide, tel qu'une pastille. Le convoyeur peut être manuel ou motorisé

De préférence, le système comprend deux bobines de réception, de préférence identiques, agencées à distance l'une derrière l'autre, et agencées relativement à la bobine d'émission de sorte à réaliser trois mesures successives lorsque le produit solide déplacé par le convoyeur est respectivement en dehors des bobines de réception, dans l'une d'entre elles puis dans l'autre d'entre elles.

Avantageusement, la partie du convoyeur passant à travers les bobines de réception est une bande ou courroie d'un convoyeur motorisé. Ainsi, on peut réaliser une intégration aisée au sein d'une ligne de production, notamment au sein d'une ligne de production d'objets solides à mélange binaire de matériaux de susceptibilité magnétique différente. Il peut s'agir de lignes de production de pastilles de combustible nucléaire MOX.

Selon la revendication indépendante 15, l'invention a enfin pour objet l'application du procédé ou du système qui viennent d'être décrits pour la mesure de concentrations massiques relatives de plutonium (Pu) et uranium (U), et des oxydes associés dans des pastilles de combustible nucléaire de type MOX. L'invention s'applique également dans le domaine du cycle du combustible nucléaire de pastilles en UOX (pour les impuretés). Elle est aussi applicable à la détection d'impuretés de type métallique dans le MOX.

Ainsi, l'invention consiste essentiellement à la mesure des concentrations relatives, soit en %, soit massique, de tout mélange composite de deux ou plus de matériaux paramagnétiques, par une pesée et une mesure de la susceptibilité magnétique globale ($\chi mel$) du mélange au moyen d'un système à bobines d'émission (excitation magnétique) et réception et une comparaison par rapport à un mélange calibré de mêmes matériaux dont le poids et les concentrations massiques sont connues.

Selon l'invention, la grandeur mesurée est donc la susceptibilité magnétique du mélange, avec une mesure à fréquence fixe ou variable et à champ magnétique d'amplitude généralement fixe, de faible amplitude, typiquement quelques mT. Ce champ faible est généré par un système à bobines simple à mettre en œuvre et compact.

Une mesure complémentaire du poids du mélange peut être réalisée.

Ainsi, si les susceptibilités des deux matériaux d'un mélange binaire sont respectivement $\chi 1$ et $\chi 2$, et la masse du mélange $m(mel)$ = m1 + $m2$, alors la susceptibilité du mélange est donnée par la relation :

$$\chi mel \ = \ \frac{m1\chi 1}{m1 + m2} + \frac{m2\chi 2}{m1 + m2}$$

Ce qui permet, connaissant $\chi 1$ et $\chi 2$, à partir de table ou de mesures des composés purs, de déduire :

$$m1 = m(mel)\left(\frac{\chi mel - \chi 2}{\chi 1 - \chi 2}\right)$$

Et

$$m2 = m(mel)\left(\frac{\chi mel - \chi 1}{\chi 2 - \chi 1}\right)$$

Ainsi, à partir de ces mesures non invasives, et de la comparaison avec une référence connue, on peut connaitre la composition du mélange.

Pour la référence connue, le poids et un signal de référence sont préalablement établis.

Le signal de référence est soit connu à partir de tables, de la littérature..., soit par une mesure de calibration préalable au moyen d'un système de mesure selon l'invention. Ainsi typiquement, pour des pastilles de MOX, une calibration avec des pastilles pures de $PuO_2$ et d'$UO_2$ peut être réalisée au préalable pour avoir le signal de référence.

Les inventeurs ont pensé judicieusement à utiliser la différence de valeur de susceptibilité magnétique de matériaux paramagnétiques dans un mélange pour évaluer leurs pourcentages massiques relatives par une mesure de susceptibilité dynamique.

La mesure de susceptibilité dynamique, appelée souvent susceptibilité AC est peu développée mais a déjà été décrite dans quelques articles.

Ainsi, la publication [1] propose un système de mesure de susceptibilité AC couvrant une large gamme de température. L'article [2] propose quant à lui un susceptomètre à deux bobines fonctionnant entre 100Hz et 100kHz.

Un système de mesure de susceptibilité dynamique AC est commercialisé par la société Quantum design.

Ces différents systèmes fonctionnent sur une large bande de fréquences et permettent d'obtenir une valeur de susceptibilité dans un temps typique de la minute pour une fréquence donnée.

En général, la mesure visée par les systèmes connus concerne une évolution de la susceptibilité en fonction d'un paramètre extérieur comme la température ou la pression, afin de remonter à des informations comme des transitions de phase d'un matériau donné.

Mais de manière surprenante, personne n'a pensé à utiliser la mesure susceptibilité dynamique AC pour mesurer un rapport de concentration massique de mélange à deux ou plus matériaux de susceptibilités magnétiques différentes.

Selon une application privilégiée, la mesure est mise en œuvre pour la connaissance de concentrations massiques relatives dans des pastilles de combustible MOX dans lesquelles, les deux oxydes d'intérêt présentent des valeurs de susceptibilité magnétique différentes, la valeur $\chi$ d'$UO_2$ étant égale à $3,0.10^{-3}$ emu.mol$^{-1}$ tandis que celle de $PuO_2$ est égale à $0,4.10^{-3}$ emu.mol$^{-1}$, d'après [3].

Au final, l'invention apporte de nombreux avantages parmi lesquels on peut citer :

- une mesure bien plus rapide que les solutions de mesures, chimiques ou par spectroscopie selon l'état de l'art. Typiquement, avec une mesure de susceptibilité AC selon l'invention, le temps de mesure par pastille de combustible MOX peut être de l'ordre de quelques secondes ;
- la possibilité d'une mesure non plus par prélèvement de quelques échantillons sur un lot de production comme selon l'état de l'art mais systématiquement pour chaque mélange produit, notamment pour chaque pastille de combustible nucléaire en production ;
- les dimensions de l'équipement et la compacité de sa partie d'acquisition de mesure (boitier et bobines logées à l'intérieur) rendent un système de mesure selon l'invention davantage facilement compatible avec un environnement nucléaire par rapport aux solutions selon l'état de l'art, notamment aux système de mesure par magnétométrie (VSM);
- un système de mesure qui peut être intégré aisément dans une ligne de production en continu de produits à mélange de matériaux, par exemple dans une chaine de fabrication/transport de pastilles ;
- la possibilité d'utiliser le procédé et le système de mesure à tout mélange composite d'au moins deux matériaux paramagnétiques ou ferromagnétiques distincts ;
- la possibilité de connaître l'homogénéité d'un mélange, à partir de l'analyse de la forme du signal de mesure, à la différence des solutions selon l'état de l'art.

D'autres avantages et caractéristiques de l'invention ressortiront mieux à la lecture de la description détaillée d'exemples de mise en œuvre de l'invention faite à titre illustratif et non limitatif en référence aux figures suivantes.

**Brève description des dessins**

[Fig 1] la figure 1 est une vue schématique en perspective d'un système pour la mesure de concentrations massiques relatives de deux matériaux d'un mélange binaire sous la forme d'une pastille solide, selon l'invention.

[Fig 2] la figure 2 est une vue photographique d'un exemple du système selon l'invention avec une partie de la connectique mise en œuvre selon l'invention.

[Fig 3A] la figure 3A illustre sous forme d'une courbe la mesure en phase pour différents composants paramagnétiques dans un système selon l'invention dont la fréquence de bobine de réception est accordée à la fréquence d'excitation.

[Fig 3B] la figure 3B illustre sous forme d'une courbe la mesure en quadrature pour les différents composants paramagnétiques comme selon la figure 3A.

[Fig 4] la figure 4 illustre sous forme d'une courbe un exemple de mesures obtenues selon l'invention, d'un échantillon à concentration variable d'un mélange binaire sous la forme d'une pastille solide.

[Fig 5] la figure 5 est une vue en perspective d'un système pour la mesure selon un mode de de réalisation de l'invention intégrant une partie d'un système de convoyage motorisé.

[Fig 6] la figure 6 est une vue en coupe du système selon la figure 5.

[Fig 7A] la figure 7A est une vue schématique illustrant une étape préalable d'aimantation d'un produit ferromagnétique selon une variante du procédé de mesure selon l'invention.

[Fig 7B] la figure 7B est une vue schématique illustrant l'étape d'insertion dans une bobine de réception du produit aimanté selon la figure 7A afin de mettre en œuvre le procédé de mesure selon l'invention.

[Fig 8] la figure 8 illustre sous forme de graphique des mesures de valeurs maximales de module de la susceptibilité magnétique, pour des échantillon contenant des nanotubes de carbone dans une matrice non ferromagnétique, les mesures étant obtenues par le procédé selon la présente invention, en fonction des moments magnétiques mesurés par VSM desdits échantillons.

## Description détaillée

Dans l'ensemble de la présente demande, les termes « inférieur », « supérieur », « bas », « haut », « dessous » et « dessus » sont à comprendre par référence par rapport à des boitiers.

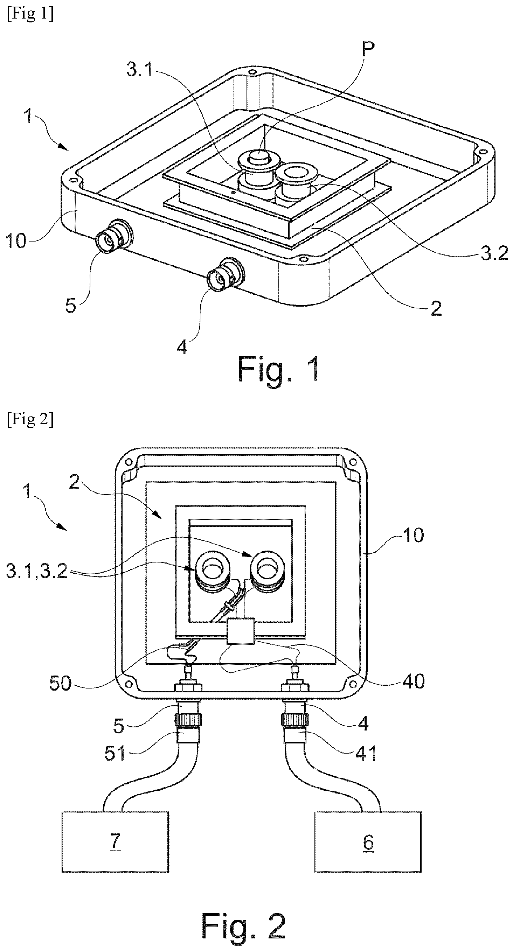

On a représenté en figures 1 et 2, un exemple de dispositif 1 formant la partie acquisition d'un système pour la mesure par susceptibilité magnétique de concentrations massiques des oxydes de Pu et U dans des pastilles de combustible MOX.

Ce dispositif 1 comprend tout d'abord un boitier 10, avantageusement de protection électromagnétique, dans lequel sont logées respectivement une bobine d'émission (excitation) 2 et deux bobines de réception 3.1, 3.2 avantageusement identiques et montées en série électrique. Les bobines d'excitation 2 et de réception 3.1, 3.2 sont ici agencées dans un même plan. Elles sont avantageusement montées avec un bobinage inversé pour que le champ d'émission donne un signal le plus faible possible dans les bobines de réception.

Dans l'exemple illustré, la bobine d'émission 2 est sous la forme d'un cadre qui loge les bobines de réception 3.1, 3.2 qui quant à elles sont chacune sous la forme d'un cylindre creux. Le diamètre et la hauteur de ce cylindre sont typiquement choisis pour y loger une pastille P de combustible MOX. Globalement, les dimensions latérales d'un boitier 10 peuvent être typiquement de l'ordre de 5 à 10 fois, le diamètre d'une pastille P. Ainsi, le boitier 10 peut être léger et très compact, ce qui permet de l'amener et le positionner aisément dans un environnement très contraignant, tel qu'une boite à gants.

Les dimensions de la bobine d'excitation 2 peuvent être réduites car le champ magnétique d'excitation recherché peut être de l'ordre de quelques mT, typiquement entre 1 et 20mT.

Un premier connecteur 4 est monté dans le boitier 10 et est relié à la bobine d'émission 2 par un premier fil d'alimentation électrique 40 à l'intérieur du boitier. Ce premier connecteur 4 est relié à distance à un générateur basse fréquence 6 par un premier câble d'alimentation électrique 41.

Un deuxième connecteur 5 est monté dans le boitier 10 et est relié aux bobines de réception 3.1 et 3.2 par un deuxième fil d'alimentation électrique 50 à l'intérieur du boitier. Ce deuxième connecteur 5 est relié à distance à un amplificateur à détection synchrone 7 par un deuxième câble d'alimentation électrique 51.

Ainsi, le boitier 10 est compact et embarque toute la partie d'acquisition de la mesure du système (bobines 2 ; 3.1, 3.2) et la connectique afférente, le générateur basse fréquence 6 et l'amplificateur 7 étant déportés de l'environnement dans lequel le boitier est implanté. Ainsi, si l'environnement est soumis à des radiations, la partie génération des signaux et la partie du traitement de signal sont immunes, c'est-à-dire protégées des radiations.

On décrit maintenant un procédé de mesure de concentrations massiques relatives de matériaux d'un mélange binaire sous la forme d'une pastille solide mis en œuvre selon l'invention notamment par le système qui vient d'être décrit.

Etape a/ : on met en place un dispositif 1 selon les figures 1 et 2 en effectuant les connexions électriques respectivement au générateur basse fréquence 6 et à un amplificateur à détection synchrone.

Les deux bobines de réception 3.1, 3.2 sont mises en parallèle à un condensateur dont la valeur est choisie pour avoir la résonance de ce circuit LC entre 50kHz et 200kHz. Pour des petites pastilles, une fréquence jusqu'à quelques MHz peut être choisie.

Etape b/ : on fournit un échantillon d'une pastille solide P de combustible MOX dont on cherche à évaluer les concentrations massiques respectives de PuOx et UOx.

Etape b1/: on fait une pesée de la pastille P. Cette étape peut être faite usuellement par une balance conventionnelle.

Etape c/ : on insère la pastille P dans la première bobine de réception 3.1 puis dans la deuxième bobine de réception 3.2, comme illustré à la figure 1.

Etape d/ : on alimente la bobine d'émission 2 par le générateur basse fréquence 6, à une fréquence d'excitation variable, non nulle de sorte à générer un champ magnétique d'excitation dans la bobine 2. L'alimentation peut être interrompue lors du passage de la pastille P de la première à la deuxième bobine de réception.

L'excitation de champ de la bobine d'excitation 2 est donc faite par l'application d'une tension donnée, typiquement de quelques volts, en faisant varier la fréquence, typiquement jusqu'à quelques 100Khz ou quelques MHz.

Etape e/ : on mesure en phase et en quadrature le signal de la tension électrique induite dans la bobine de réception 3.1, puis dans celle de la bobine de réception 3.2 pour chaque fréquence d'excitation.

Les tensions mesurées aux bornes de ces deux bobines 3.1, 3.2 sont avantageusement soustraites puis amplifiées par l'amplificateur à détection synchrone 7.

En l'absence de pastille P, le signal obtenu en sortie des deux bobines 3.1, 3.2 sous application du champ d'excitation est nul ou équilibré pour être proche de zéro. Sa valeur peut être notée égale à V0.

Le fait de faire la mesure par différence entre les signaux issus des deux bobines de réception permet de supprimer le décalage à rajouter à la valeur V0. Ainsi, on supprime la nécessité d'une mesure à vide préalable.

En présence de la pastille P dans la première bobine de réception 3.1, le signal de réception a une valeur V1=V0+dV, et lorsque la pastille P est dans la deuxième bobine 3.2, la valeur du signal V2=V0-dV.

Ainsi, la différence, soit V1-V2=2dV, où dV est proportionnel à la susceptibilité magnétique complexe de la pastille P.

A chaque point de fréquence mesurée, le signal en sortie mesurée par l'amplificateur 7 permet d'accéder au signal en phase et en quadrature par rapport au signal d'excitation, à la fréquence mesurée.

Typiquement, des mesures entre 1 et 20 points de fréquence autour de la fréquence de résonance de la détection peuvent être réalisées.

Les signaux en phase et quadrature donnent une information sur la susceptibilité magnétique complexe de la pastille (composantes réelle X et imaginaire Y ; $\chi = X + iY$) à la fréquence de mesure. Lorsque le procédé de l'invention mesure uniquement le signal en phase, la mesure obtenue est proportionnelle à la partie réelle de la susceptibilité magnétique et lorsque le procédé de l'invention mesure le signal en phase et le signal en quadrature, la mesure obtenue permet d'accéder aux composantes réelle et imaginaire et donc au module.

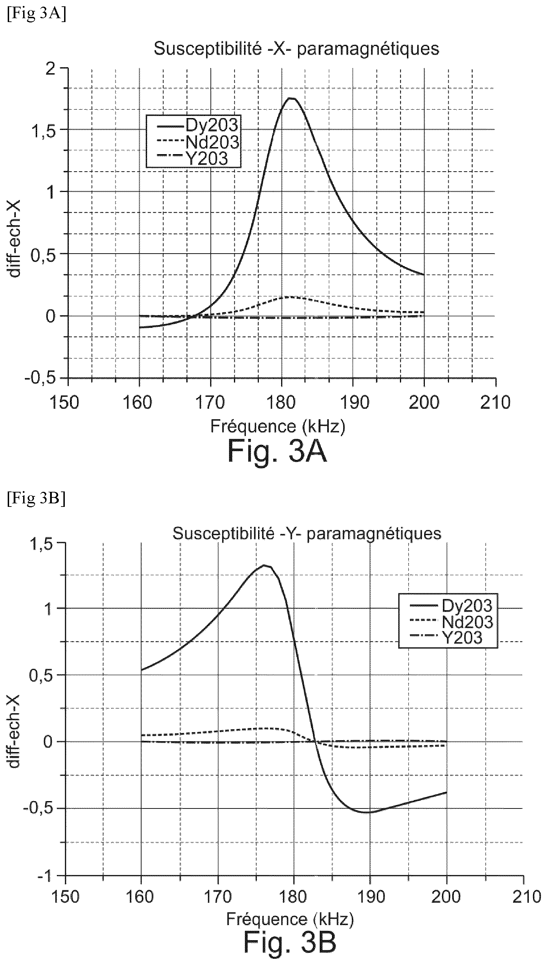

Un exemple de mesures en phase et quadrature pour différents matériaux paramagnétiques dans un système 1 selon l'invention dont la fréquence de réception a été accordée autour de 180kHz est montré aux figures 3A et 3B.

Les différents matériaux testés sont un oxyde du dysprosium, de formule $Dy_2O_3$, un oxyde de néodyme, de formule $Nd_2O_3$ et un oxyde d'yttrium de formule $Y_2O_3$.

Etape f:/

A partir d'un balayage en fréquence sur la plage de fréquences d'excitation envisagée, on peut extraire de ces mesures sur ladite plage de fréquences, le module M et l'intégrale I selon les équations suivantes.

[Equation 1]

$$M = \sqrt{X^2 + Y^2}$$

[Equation 2]

$$I = \sum_{f_0}^{f_n} M_n$$

Ces valeurs de module et d'intégrale permettant ensuite une comparaison quantitative de l'échantillon (pastille) considérée par rapport à un échantillon de référence dont les concentrations massiques relatives des deux matériaux sont connues.

Avec la comparaison des masses entre l'échantillon mesuré et l'échantillon de référence, on détermine au final les concentrations massiques des deux matériaux dans l'échantillon.

Typiquement, pour une pastille P de MOX, la comparaison est établie par rapport à une pastille pure de $PuO_2$ et

d'UO$_2$ de masse.

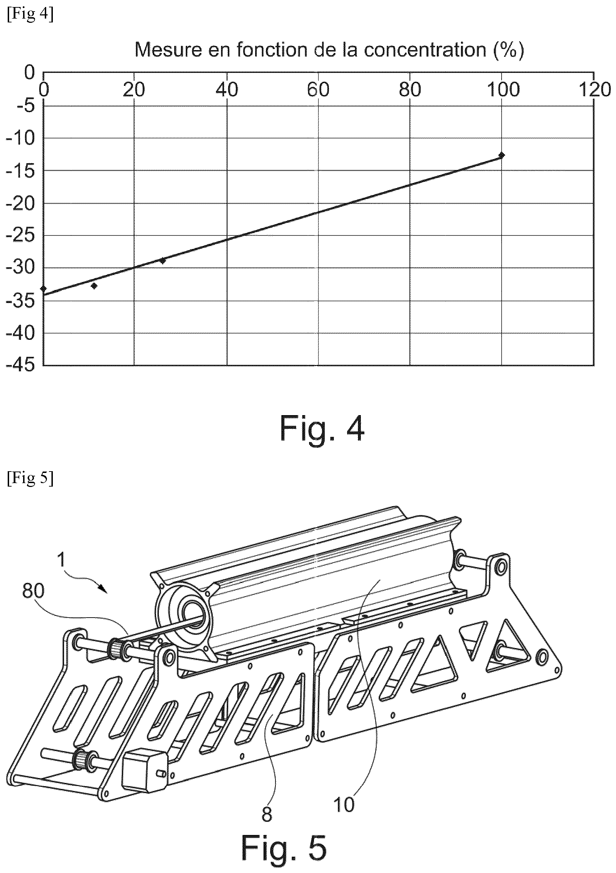

La figure 4 illustre des mesures d'échantillons à concentration variable d'un mélange de deux matériaux de susceptibilité magnétique différente, obtenues conformément au procédé qui vient d'être décrit. On précise que sur cette figure 4, l'abscisse représente la concentration en % et l'ordonnée représente l'intégrale du signal (unités arbitraires), détecté par l'amplificateur 7.

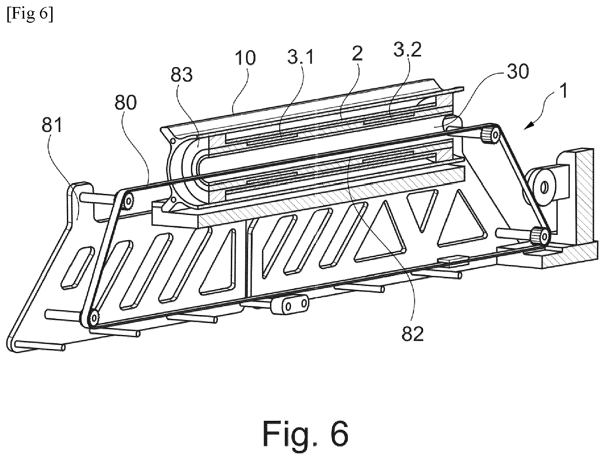

Les figures 5 à 6 montrent un dispositif alternatif à celui montré en figures 1 et 2.

Dans ce dispositif, les bobines de réception 3.1, 3.2 sont agencées coaxialement à l'intérieur de la bobine d'émission 2 en définissant en leur sein un passage 30 d'une partie d'un convoyeur 8 à bande 80, adapté pour déplacer le mélange sous la forme d'un produit solide, tel qu'une pastille.

Plus précisément, le convoyeur 8 comprend un bâti 81 supportant le boitier de blindage électromagnétique 10 formé par un cylindre extérieur et un cylindre intérieur 82 séparé par des entretoises 83 et, dont l'intérieur définit le passage 30 des pastilles à mesurer.

Entre les entretoises 83 et le cylindre extérieur 10 est agencée la bobine d'excitation 2 sous la forme d'un cylindre coaxial.

Entre les entretoises 83 et le cylindre intérieur 82 sont agencées à distance l'une de l'autre les deux bobines de réception 3.1, 3.2, chacune sous la forme d'un cylindre coaxial.

Ce dispositif permet un transport automatisé des échantillons à mesurer de la première bobine de réception 3.1 à l'autre 3.2.

L'échantillon est transporté par un système manuel ou motorisé le long du cylindre d'excitation 2 de la première à la seconde bobine par déplacement de la bande ou courroie de convoyage 80.

Le transport de l'échantillon permet d'atteindre trois positions de mesures, à savoir respectivement à vide lorsque l'échantillon n'est dans aucune des bobines de réception, lorsque l'échantillon est dans la première bobine de réception 3.1, puis lorsqu'il est dans la deuxième bobine de réception 3.2.

Pour la mesure, l'échantillon passe de préférence à vitesse constante au sein de chacune des deux bobines de réception 3.1, 3.2. Cela a pour avantage de ne pas réduire notablement voire pas du tout la cadence d'une ligne de production.

Pour augmenter la vitesse de mesure, on peut réaliser la mesure sur un nombre discret de fréquences, typiquement un nombre de trois mesures fait en simultané. Dans le cas d'une mesure encore plus rapide, une seule fréquence est utilisée et le signal n'est mesuré que dans une seule des bobines de réception 3.1, 3.2.

En effet, il est simple d'envoyer une fréquence unique et de mesurer en détection synchrone, à cette fréquence, la réponse de l'échantillon. Il est aussi possible d'envoyer trois fréquences en simultané avec par exemple un générateur arbitraire de fréquences et de mesurer en détection avec un nombre de trois modulateurs synchrones sur ces trois fréquences. Cela permet par ajustement de reconstruire la réponse fréquentielle du système en une seule mesure au lieu de faire des mesures a différentes fréquences les unes après les autres.

Il va de soi qu'on peut augmenter ou diminuer le nombre de fréquences en simultané, par exemple à 2 ou 4 ou plus.

Lorsque l'échantillon est centré sur le cylindre d'une bobine de réception, i.e. son plan médian est sensiblement confondu avec celui de la bobine, alors le signal reçu est maximal et dépend du rapport de concentration des matériaux dans l'échantillon.

Si le passage des échantillons est continu, une mesure répétitive peut être réalisée afin de déterminer le signal lorsque l'échantillon est au centre de la bobine de réception, qui correspond au maximum du signal reçu.

A partir d'une mesure indépendante de masse réalisée en complément de la mesure du signal maximal obtenu, on détermine comme décrit précédemment le rapport de concentrations massiques des matériaux dans l'échantillon.

On peut mettre en œuvre le procédé et système qui viennent d'être décrits pour un échantillon ferromagnétique.

Dans ce cas, on réalise une étape supplémentaire b2/ consistant à exposer l'échantillon à un champ magnétique constant.

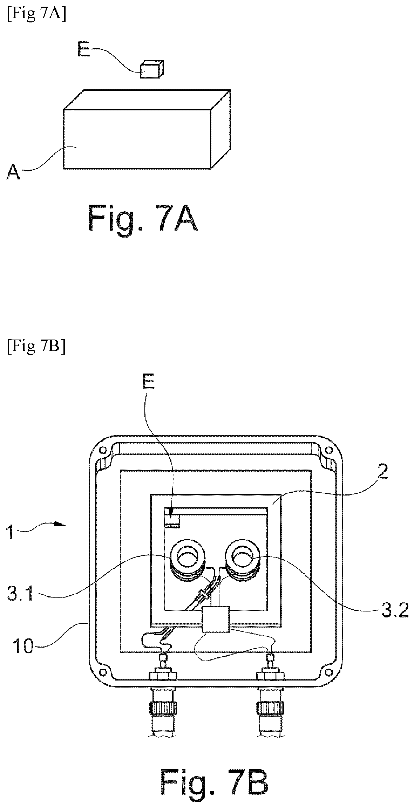

Cela est montré à la figure 7A où l'échantillon E est pré-aimanté au moyen d'un aimant permanent puis inséré dans la première bobine de réception 3.1 comme selon la figure 1.

Puis on réalise les étapes d / à e/ de mesure précitées.

Les inventeurs ont réalisé des mesures de module M de susceptibilités magnétiques complexes de différents échantillons contenant chacun des quantités variables de nanotubes de carbone, connus pour leur signature ferromagnétique du fer utilisé pour la synthèse, dans une matrice non ferromagnétique. Ils ont comparé les résultats obtenus avec les moments magnétiques mesurés par VSM.

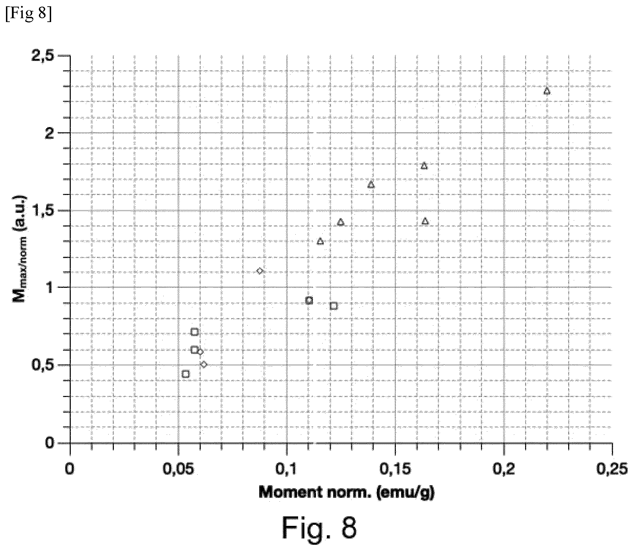

Les résultats comparatifs sont illustrés à la figure 8, dans laquelle les valeurs maximales des modules mesurés (en ordonnée) par le procédé selon la présente invention sont fonction des moments magnétiques mesurés par VSM (en abscisse), les valeurs maximales des modules (M$_{max/norm}$) et les moments magnétiques (Moment norm.) étant normalisés par les masses respectives des échantillons. Dans cette figure 8, les carrés représentent les échantillons dont la concentration en nanotubes de carbone est proche de 0,5 % en masse, les losanges représentent les échantillons dont la concentration en nanotubes de carbone est proche de 1,0 % en masse, les triangles représentent les échantillons dont la concentration en nanotubes de carbone est proche de 2,0 % en masse.

Comme cela peut être observé à la figure 8, il existe bel et bien une relation linéaire entre les valeurs maximales des modules et les moments magnétiques. Ainsi, la mesure du module, ou encore de l'intégrale, de la susceptibilité magnétique est bien proportionnelle à la quantité de matière ferromagnétique.

L'invention n'est pas limitée aux exemples qui viennent d'être décrits ; on peut notamment combiner entre elles des caractéristiques des exemples illustrés au sein de variantes non illustrées.

D'autres variantes et améliorations peuvent être envisagées sans pour autant sortir du cadre de l'invention.

Plusieurs autres configurations et agencements de bobines que celles montrées dans les différentes figures, notamment en cas d'environnement moins contraignant en termes d'encombrement et/ou car non nucléaire.

Le procédé selon l'invention fonctionne avec une seule bobine de réception. Dans ce cas, une mesure préalable à vide pourra être réalisée, afin d'obtenir le signal de base qui correspond au décalage moins la valeur V0.

Au lieu d'utiliser un amplificateur à détection synchrone, on peut envisager de mesurer avec une précision suffisante le signal de chacune des bobines de réception et de faire la différence entre leurs signaux uniquement de façon numérique.

**Liste des références citées :**

[1]: Review of Scientific Instruments 60, 113 (1989); https://doi.org/10.1063/1.1140593

[2]: Review of Scientific Instruments 84, 125105 (2013); https://doi.org/10.1063/1.4842255.

[3]:« *MAGNETIC SUSCEPTIBILITY OF THE ELEMENTS AND INORGANIC COMPOUNDS* »; http://www.fizika.si/magnetism/MagSusceptibilities.pdf.

**Revendications**

1. Procédé de mesure de concentrations relatives de matériaux d'un mélange comprenant les étapes suivantes:

   a/ fourniture d'une bobine d'émission (2) et d'au moins une bobine de réception (3.1, 3.2);
   b/ fourniture d'un mélange (P, E) comprenant n matériaux de susceptibilités magnétiques différentes ($\chi 1$, $\chi 2$, .. $\chi^n$) ;
   c/ insertion du mélange dans la au moins une bobine de réception;
   d/ alimentation par un générateur de tension électrique de la bobine d'émission à au moins une fréquence d'excitation, non nulle de sorte à générer un champ magnétique d'excitation ;
   e/ mesure du signal de la tension électrique induite dans la au moins une bobine de réception;
   f/ détermination des concentrations relatives des n matériaux à partir de la comparaison de susceptibilité globale du mélange obtenue par la mesure de tension selon l'étape e/ avec celle d'un mélange de référence dont les concentrations relatives desdits n matériaux sont connues,

   le procédé étant **caractérisé en ce que** l'étape d/ comprend l'application de la tension électrique donnée en faisant varier la au moins une fréquence d'excitation.

2. Procédé de mesure selon la revendication 1, le mélange fourni selon l'étape b/ étant un mélange binaire de matériaux de deux susceptibilités magnétiques différentes ($\chi 1$, $\chi 2$) ou un mélange comprenant plus de deux matériaux, l'un des matériaux présentant une susceptibilité très supérieure, d'un facteur 100, à celle des autres matériaux.

3. Procédé de mesure selon l'une quelconque des revendications précédentes, comprenant après l'étape b), une étape b1/ comportant une pesée du mélange de sorte à obtenir à l'étape f) une concentration massique relative dudit mélange,

   de préférence le mélange fourni selon l'étape b/ étant un mélange binaire de matériaux de deux susceptibilités magnétiques différentes ($\chi 1$, $\chi 2$), le procédé comprenant à l'étape f à partir de la masse du mélange m(mel) =m1+m2 obtenue selon l'étape b1/, la détermination de la susceptibilité du mélange donnée par la relation :

$$\chi mel = \frac{m1\chi1}{m1 + m2} + \frac{m2\chi2}{m1 + m2}$$

et connaissant les susceptibilités magnétiques différentes ($\chi1$, $\chi2$), la détermination des concentrations massiques respectives des matériaux par les relations suivantes :

$$m1 = m(mel)\left(\frac{\chi mel - \chi2}{\chi1 - \chi2}\right)$$

et

$$m2 = m(mel)\left(\frac{\chi mel - \chi1}{\chi2 - \chi1}\right).$$

4. Procédé de mesure selon l'une quelconque des revendications précédentes , comportant en outre, à l'étape e/ une mesure en phase du signal de la tension électrique induite dans la au moins une bobine de réception et /ou une mesure en quadrature de phase de sorte à obtenir le module du signal.

5. Procédé de mesure selon l'une des revendications précédentes, l'étape a/ comprenant la fourniture d'une unique bobine de réception, le procédé comprenant en outre avant l'étape c/, la réalisation des étapes d/ et e/ de sorte à obtenir un signal de base représentatif de l'unique bobine de réception vide,
ou l'étape a/ comprenant la fourniture de deux bobines de réception, de préférence identiques, le procédé comprenant avant l'étape f/, la réitération des étapes c/ à e/ avec chacune des deux bobines de réception, et une étape supplémentaire e1/ de soustraction entre les deux mesures des signaux induits par les deux bobines, le procédé comprenant de préférence la mise en série électrique des deux bobines de réception et l'accord de leurs fréquences de réception respectives.

6. Procédé selon l'une des revendications précédentes, l'étape e/ étant réalisée pour chaque fréquence d'excitation, avec une détection synchrone.

7. Procédé de mesure selon l'une des revendications précédentes, l'étape e/ consistant en plusieurs mesures, chacune à une fréquence de réception autour de la fréquence de résonance de la ou des bobines de détection.

8. Procédé de mesure selon l'une des revendications précédentes, l'étape d/ étant réalisée de sorte à générer un champ magnétique d'excitation de valeur inférieure à 50mT, de préférence compris entre 1 et 20mT.

9. Procédé de mesure selon l'une des revendications précédentes, lorsque le mélange comprend un matériau ferromagnétique, comprenant avant l'étape c/, une étape supplémentaire b2/ consistant à exposer le mélange à un champ magnétique constant.

10. Système (1) pour la mesure de concentrations relatives de n matériaux d'un mélange, comprenant:

- un générateur (6) de tension électrique à au moins une fréquence dite d'excitation, le générateur étant un générateur basse fréquence (GBF) à fréquence variable ;
- une bobine d'émission (2) reliée au générateur;
- au moins une bobine de réception (3.1, 3.2) dont la forme est adaptée pour recevoir un mélange comprenant n matériaux de susceptibilités magnétiques différentes ($\chi^1$, $\chi^2$,..$\chi^n$) et dont la fréquence de réception est accordée à la au moins une fréquence d'excitation;
des moyens de mesure de la tension (7) reliés à la (ou les) bobine (s) de réception, de préférence les moyens de mesure comprenant un amplificateur à détection synchrone;
le système (1) étant configuré pour déterminer des concentrations relatives des n matériaux à partir de la comparaison de susceptibilité globale du mélange obtenue par la mesure de tension (7) avec celle d'un mélange de référence dont les concentrations relatives desdits n matériaux sont connues; le système (1) étant **caractérisé en ce que** le générateur (6) est configuré pour appliquer la tension donnée en faisant varier la au moins une fréquence d'excitation.

11. Système (1) selon la revendication 10, comprenant deux bobines de réception (3.1, 3.2) en série électrique et dont leurs fréquences de réception respectives sont accordées.

**12.** Système (1) selon l'une des revendications 10 et 11, la(les) bobine(s) de réception (3.1, 3.2) étant agencée(s) à l'intérieur de la bobine d'excitation (2).

**13.** Système (1) selon l'une des revendications 10 à 12, comprenant en outre :

  - un boitier (10), de préférence de protection électromagnétique ;
  - un premier connecteur (4) monté dans le boitier, relié à la bobine d'émission par un premier fil d'alimentation électrique (40) à l'intérieur du boitier; le premier connecteur étant destiné à être relié à distance au générateur par un premier câble d'alimentation électrique (41);
  - un deuxième connecteur (5) monté dans le boitier, relié à au moins une bobine de réception par un deuxième fil d'alimentation électrique (50) à l'intérieur du boitier; le deuxième connecteur étant destiné à être relié à distance aux moyens de mesure par un deuxième câble d'alimentation électrique (51).

**14.** Système (1) selon l'une des revendications 10 à 13, la ou les bobines de réception (3.1, 3.2) étant agencées coaxialement à l'intérieur de la bobine d'émission (2) en définissant en leur sein un passage d'une partie d'un convoyeur (8) adapté pour déplacer le mélange sous la forme d'un produit solide, tel qu'une pastille, le système comprenant de préférence les deux bobines de réception (3.1, 3.2), de préférence identique, agencées à distance l'une derrière l'autre, et agencées relativement à la bobine d'émission (2) de sorte à réaliser trois mesures successives lorsque le produit solide déplacé par le convoyeur (8) est respectivement en dehors des bobines de réception, dans l'une d'entre elles puis dans l'autre d'entre elles, de préférence la partie du convoyeur passant à travers les bobines de réception étant une bande (80) ou courroie d'un convoyeur motorisé.

**15.** Application du procédé selon l'une des revendications 1 à 9 pour la mesure de concentrations massiques relatives de plutonium (Pu) et uranium (U), et des oxydes associés dans des pastilles de combustible nucléaire de type MOX.

**Patentansprüche**

**1.** Verfahren zur Messung von relativen Konzentrationen von Materialien einer Mischung, beinhaltend die folgenden Schritte:

  a/ Bereitstellen einer Sendespule (2) und mindestens einer Empfangsspule (3.1, 3.2);
  b/ Bereitstellen einer Mischung (P, E), die n Materialien mit unterschiedlichen magnetischen Suszeptibilitäten ($\chi^1, \chi^2, ..\chi^n$) beinhaltet;
  c/ Einführen der Mischung in die mindestens eine Empfangsspule;
  d/ Versorgen, durch einen Generator elektrischer Spannung, der Sendespule mit mindestens einer Anregungsfrequenz ungleich Null, um ein Anregungsmagnetfeld zu erzeugen;
  e/ Messen des Signals der elektrischen Spannung, die in der mindestens einen Empfangsspule induziert wird;
  f/ Bestimmen der relativen Konzentrationen der n Materialien durch das Vergleichen der Gesamtsuszeptibilität der Mischung, die durch die Spannungsmessung in Schritt e/ erhalten wird, mit der einer Referenzmischung, von der die relativen Konzentrationen der n Materialien bekannt sind, wobei das Verfahren **dadurch gekennzeichnet ist, dass** Schritt d/ das Anlegen der gegebenen elektrischen Spannung bei gleichzeitiger Variierung der mindestens einen Anregungsfrequenz beinhaltet.

**2.** Messverfahren nach Anspruch 1, wobei die in Schritt b/ bereitgestellte Mischung eine binäre Mischung von Materialien mit zwei unterschiedlichen magnetischen Suszeptibilitäten ($\chi^1, \chi^2$) oder eine Mischung, die mehr als zwei Materialien beinhaltet, ist, wobei eines der Materialien eine Suszeptibilität aufweist, die sehr viel größer, um einen Faktor 100 größer, als die der anderen Materialien ist.

**3.** Messverfahren nach einem der vorhergehenden Ansprüche, beinhaltend, nach Schritt b), einen Schritt b1/, der ein Wiegen der Mischung umfasst, um in Schritt f) eine relative Massenkonzentration der Mischung zu erhalten, wobei die in Schritt b/ bereitgestellte Mischung vorzugsweise eine binäre Mischung von Materialien mit zwei unterschiedlichen magnetischen Suszeptibilitäten ($\chi^1, \chi^2$) ist, wobei das Verfahren in Schritt f) Folgendes beinhaltet: anhand der in Schritt b1/ erhaltenen Masse der Mischung m(misch)=m1+m2, das Bestimmen der Suszeptibilität der Mischung, die durch die folgende Gleichung gegeben ist:

$$\chi\text{misch} = \frac{m1\chi1}{m1+m2} + \frac{m2\chi2}{m1+m2}$$

und in Kenntnis der unterschiedlichen magnetischen Suszeptibilitäten ($\chi^1$,$\chi2$), das Bestimmen der jeweiligen Massenkonzentrationen der Materialien durch die folgenden Gleichungen:

$$m1 = m(\text{misch})\left(\frac{\chi\text{misch} - \chi2}{\chi1 - \chi2}\right)$$

und

$$m2 = m(\text{misch})\left(\frac{\chi\text{misch}-\chi1}{\chi2-\chi1}\right).$$

4. Messverfahren nach einem der vorhergehenden Ansprüche, ferner umfassend, in Schritt e/, eine In-Phase-Messung des Signals der in der mindestens einen Empfangsspule induzierten elektrischen Spannung und/oder eine phasenverschobene Messung, um den Modul des Signals zu erhalten.

5. Messverfahren nach einem der vorhergehenden Ansprüche, wobei Schritt a/ das Bereitstellen einer einzelnen Empfangsspule beinhaltet, wobei das Verfahren vor Schritt c/ ferner das Durchführen der Schritte d/ und e/ beinhaltet, um ein Basissignal zu erhalten, das für die leere einzelne Empfangsspule repräsentativ ist, oder wobei Schritt a/ das Bereitstellen von zwei, vorzugsweise identischen, Empfangsspulen beinhaltet, wobei das Verfahren vor Schritt f/ das Wiederholen der Schritte c/ bis e/ mit jeder der zwei Empfangsspulen und einen zusätzlichen Schritt e1/ einer Subtraktion zwischen den zwei Messungen der durch die zwei Spulen induzierten Signale beinhaltet, wobei das Verfahren vorzugsweise die elektrische Reihenschaltung der zwei Empfangsspulen und die Abstimmung ihrer jeweiligen Empfangsfrequenzen beinhaltet.

6. Verfahren nach einem der vorhergehenden Ansprüche, wobei Schritt e/ für jede Anregungsfrequenz mit einer synchronen Detektion durchgeführt wird.

7. Messverfahren nach einem der vorhergehenden Ansprüche, wobei Schritt e/ aus mehreren Messungen, jede bei einer Empfangsfrequenz um die Resonanzfrequenz der Detektionsspule(n) herum, besteht.

8. Messverfahren nach einem der vorhergehenden Ansprüche, wobei Schritt d/ so durchgeführt wird, dass ein Anregungsmagnetfeld mit einem Wert kleiner als 50 mT, vorzugsweise zwischen 1 und 20 mT, erzeugt wird.

9. Messverfahren nach einem der vorhergehenden Ansprüche, wenn die Mischung ein ferromagnetisches Material beinhaltet, beinhaltend, vor Schritt c/, einen zusätzlichen Schritt b2/, der darin besteht, die Mischung einem konstanten Magnetfeld auszusetzen.

10. System (1) zur Messung von relativen Konzentrationen von n Materialien einer Mischung, beinhaltend

- einen Generator (6) elektrischer Spannung mit mindestens einer sogenannten Anregungsfrequenz, wobei der Generator ein Niederfrequenzgenerator (GBF) mit variabler Frequenz ist;
- eine Sendespule (2), die mit dem Generator verbunden ist;
- mindestens eine Empfangsspule (3.1, 3.2), deren Form dazu angepasst ist, eine Mischung aufzunehmen, die n Materialien mit unterschiedlichen magnetischen Suszeptibilitäten ($\chi^1$, $\chi^2$, ..$\chi^n$) beinhaltet, und deren Empfangsfrequenz auf die mindestens eine Anregungsfrequenz abgestimmt ist;
Mittel zum Messen der Spannung (7), die mit der (oder den) Empfangsspule(n) verbunden sind, wobei die Messmittel vorzugsweise einen Lock-In-Verstärker beinhalten;
wobei das System (1) dazu konfiguriert ist, relative Konzentrationen von n Materialien durch das Vergleichen der Gesamtsuszeptibilität der Mischung, die durch die Spannungsmessung (7) erhalten wird, mit der einer Referenzmischung, von der die relativen Konzentrationen der n Materialien bekannt sind, zu bestimmen;
wobei das System (1) **dadurch gekennzeichnet ist, dass** der Generator (6) dazu konfiguriert ist, die gegebene Spannung bei gleichzeitiger Variierung der mindestens einen Anregungsfrequenz anzulegen.

**11.** System (1) nach Anspruch 10, beinhaltend zwei Empfangsspulen (3.1, 3.2) in Reihenschaltung, deren jeweilige Empfangsfrequenzen abgestimmt sind.

**12.** System (1) nach einem der Ansprüche 10 und 11, wobei die Empfangsspule(n) (3.1, 3.2) im Inneren der Anregungsspule (2) angeordnet ist/sind.

**13.** System (1) nach einem der Ansprüche 10 bis 12, ferner beinhaltend:

- ein Gehäuse (10), vorzugsweise zur elektromagnetischen Abschirmung;
- einen ersten Verbinder (4), der in dem Gehäuse montiert und durch einen ersten elektrischen Versorgungsdraht (40) im Inneren des Gehäuses mit der Sendespule verbunden ist; wobei der erste Verbinder dazu bestimmt ist, durch ein erstes elektrisches Versorgungskabel (41) mit dem Generator fernverbunden zu sein;
- einen zweiten Verbinder (5), der in dem Gehäuse montiert und durch einen zweiten elektrischen Versorgungsdraht (50) im Inneren des Gehäuses mit mindestens einer Empfangsspule verbunden ist; wobei der zweite Verbinder dazu bestimmt ist, durch ein zweites elektrisches Versorgungskabel (51) mit den Messmitteln fernverbunden zu sein.

**14.** System (1) nach einem der Ansprüche 10 bis 13, wobei die Empfangsspule(n) (3.1, 3.2) im Inneren der Sendespule (2) koaxial angeordnet sind und in ihrem Inneren einen Durchgang für einen Teil eines Förderers (8) definieren, der dazu angepasst ist, die Mischung in Form eines festen Produkts, wie etwa einer Tablette, zu transportieren, wobei das System vorzugsweise die zwei, vorzugsweise identischen, Empfangsspulen (3.1, 3.2) beinhaltet, die mit Abstand hintereinander angeordnet sind und relativ zu der Sendespule (2) so angeordnet sind, dass drei aufeinanderfolgende Messungen durchgeführt werden, wenn sich das durch den Förderer (8) transportierte feste Produkt jeweils außerhalb der Empfangsspulen, in einer von ihnen und dann in der anderen von ihnen befindet, wobei der Teil des Förderers, der durch die Empfangsspulen hindurchgeht, vorzugsweise ein Band (80) oder Gurt eines motorisierten Förderers ist.

**15.** Anwendung des Verfahrens nach einem der Ansprüche 1 bis 9 zur Messung von relativen Massenkonzentrationen von Plutonium (Pu) und Uran (U) und der damit verbundenen Oxide in Kernbrennstofftabletten vom Typ MOX.

## Claims

**1.** Method for measuring relative concentrations of materials of a mixture, comprising the following steps:

a/ providing an emission coil (2) and at least one reception coil (3.1, 3.2);
b/ providing a mixture (P, E) comprising n materials with different magnetic susceptibilities ($\chi 1$, $\chi 2$, ..$\chi^n$);
c/ introducing the mixture into the at least one reception coil;
d/ using an electric voltage generator to supply the emission coil with at least one non-zero excitation frequency so as to generate an excitation magnetic field,
e/ measuring the signal of the electric voltage induced in the at least one reception coil;
f/ determining the relative concentrations of the n materials based on a comparison between the overall susceptibility of the mixture obtained by the voltage measurement according to step e/ and that of a reference mixture for which the relative concentrations of said n materials are known, the method being **characterized in that** step d/ comprises applying the given electric voltage by varying the at least one excitation frequency.

**2.** Measurement method according to Claim 1, with the mixture provided according to step b/ being a binary mixture of materials with two different magnetic susceptibilities ($\chi 1$, $\chi 2$) or a mixture comprising more than two materials, with one of the materials having a much higher susceptibility, by a factor of 100, than that of the other materials.

**3.** Measurement method according to either one of the preceding claims, comprising, after step b), a step b1/ comprising weighing the mixture so as to obtain, in step f), a relative mass concentration of said mixture,

with the mixture provided according to step b/ preferably being a binary mixture of materials with two different magnetic susceptibilities ($\chi 1$, $\chi 2$), the method comprising, in step f), based on the mass of the mixture m(mix) = m1 + m2 obtained according to step b1/, determining the susceptibility of the mixture provided using the relationship:

$$\chi\text{mix} = \frac{m1\chi1}{m1 + m2} + \frac{m2\chi2}{m1 + m2}$$

and, knowing the different magnetic susceptibilities ($\chi1$, $\chi2$), determining the respective mass concentrations of the materials using the following relationships:

$$m1 = m(\text{mix})\left(\frac{\chi\text{mix} - \chi2}{\chi1 - \chi2}\right)$$

and

$$m2 = m(\text{mix})\left(\frac{\chi\text{mix} - \chi1}{\chi2 - \chi1}\right).$$

4. Measurement method according to any one of the preceding claims, further comprising, in step e/, an in-phase measurement of the signal of the electric voltage induced in the at least one reception coil and/or a phase quadrature measurement so as to obtain the modulus of the signal.

5. Measurement method according to one of the preceding claims, with step a/ comprising providing a single reception coil, the method further comprising, before step c/, carrying out steps d/ and e/ so as to obtain a basic signal representing the empty single reception coil,
or with step a/ comprising providing two, preferably identical, reception coils, the method comprising, before step f/, repeating steps c/ to e/ with each of the two reception coils, and an additional step e1/ of subtracting, between the two measurements, the signals induced by the two coils, the method preferably comprising electrically connecting the two reception coils in series and tuning their respective reception frequencies.

6. Method according to one of the preceding claims, with step e/ being carried out for each excitation frequency, with synchronous detection.

7. Measurement method according to one of the preceding claims, with step e/ being made up of several measurements, each at a reception frequency around the resonant frequency of the one or more detection coils.

8. Measurement method according to one of the preceding claims, with step d/ being carried out so as to generate an excitation magnetic field with a value of less than 50 mT, preferably ranging between 1 and 20 mT.

9. Measurement method according to one of the preceding claims, when the mixture comprises a ferromagnetic material, comprising, before step c/, an additional step b2/ involving exposing the mixture to a constant magnetic field.

10. System (1) for measuring relative concentrations of n materials of a mixture, comprising:

- an electric voltage generator (6) for generating at least one frequency, called excitation frequency, the generator being a variable-frequency low-frequency generator (LFG);
- an emission coil (2) connected to the generator;
- at least one reception coil (3.1, 3.2), the shape of which is adapted to receive a mixture comprising n materials with different magnetic susceptibilities ($\chi^1$, $\chi^2$, ..$\chi^n$) and the reception frequency of which is tuned to the at least one excitation frequency;
voltage measurement means (7) connected to the one or more reception coils, with the measurement means preferably comprising a synchronous detection amplifier; the system (1) being configured to determine relative concentrations of the n materials based on a comparison between the overall susceptibility of the mixture obtained by the voltage measurement (7) and that of a reference mixture for which the relative concentrations of said n materials are known;
the system (1) being **characterized in that** the generator (6) is configured to apply the given voltage by varying the at least one excitation frequency.

11. System (1) according to Claim 10, comprising two reception coils (3.1, 3.2) electrically connected in series, the respective reception frequencies of which are tuned.

12. System (1) according to either of Claims 10 and 11, with the one or more reception coils (3.1, 3.2) being arranged inside the excitation coil (2).

13. System (1) according to one of Claims 10 to 12, further comprising:

   - a housing (10), preferably for electromagnetic protection;
   - a first connector (4) mounted in the housing, connected to the emission coil by a first power supply wire (40) inside the housing; with the first connector being intended to be remotely connected to the generator by a first power supply cable (41);
   - a second connector (5) mounted in the housing, connected to at least one reception coil by a second power supply wire (50) inside the housing; with the second connector being intended to be remotely connected to the measurement means by a second power supply cable (51).

14. System (1) according to one of Claims 10 to 13, with the one or more reception coils (3.1, 3.2) being coaxially arranged inside the emission coil (2) by defining a passage therein for a portion of a conveyor (8) adapted to move the mixture in the form of a solid product, such as a pellet, the system preferably comprising the two, preferably identical, reception coils (3.1, 3.2) remotely arranged one behind the other, and arranged relative to the emission coil (2) so as to carry out three successive measurements when the solid product moved by the conveyor (8) is respectively outside the reception coils, in one of the reception coils and then in the other one of the reception coils, with the portion of the conveyor passing through the reception coils preferably being a band (80) or a belt of a motorized conveyor.

15. Application of the method according to one of Claims 1 to 9 for measuring relative mass concentrations of plutonium (Pu) and uranium (U), and associated oxides in MOX-type nuclear fuel pellets.

[Fig 1]

Fig. 1

[Fig 2]

Fig. 2

[Fig 3A]

**Susceptibilité -X- paramagnétiques**

Fig. 3A

[Fig 3B]

**Susceptibilité -Y- paramagnétiques**

Fig. 3B

[Fig 4]

## Mesure en fonction de la concentration (%)

## Fig. 4

[Fig 5]

## Fig. 5

[Fig 6]

Fig. 6

[Fig 7A]

Fig. 7A

[Fig 7B]

Fig. 7B

[Fig 8]

Fig. 8

## RÉFÉRENCES CITÉES DANS LA DESCRIPTION

**Documents brevets cités dans la description**

- JP S60114766 A
- US 4134064 A
- FR 2433181 A1

**Littérature non-brevet citée dans la description**

- *Review of Scientific Instruments*, 1989, vol. 60, 113, https://doi.org/10.1063/1.1140593
- *Review of Scientific Instruments*, 2013, vol. 84, 125105, https://doi.org/10.1063/1.4842255